(19) Europäisches Patentamt
European Patent Office
Office européen des brevets

(11) Veröffentlichungsnummer: **0 009 216**
**A2**

# (12) EUROPÄISCHE PATENTANMELDUNG

(21) Anmeldenummer: **79103440.8**

(22) Anmeldetag: **14.09.79**

(51) Int. Cl.³: **G 03 C 1/68,** C 08 G 59/16, C 08 G 18/67

(30) Priorität: **26.09.78 DE 2841880**

(43) Veröffentlichungstag der Anmeldung: **02.04.80 Patentblatt 80/7**

(84) Benannte Vertragsstaaten: **CH DE FR GB IT NL**

(71) Anmelder: **BAYER Aktiengesellschaft, Zentralbereich Patente,Marken und Lizenzen Bayerwerk, D-5090 Leverkusen 1 (DE)**

(72) Erfinder: **Rosenkranz, Hans Jürgen, Dr., Heinrich-Kauert-Weg 9, D-4150 Krefeld (DE)**

## (54) Trockenfotoresistzusammensetzung und lagerfähige unvernetzte fotopolymerisierbare Trockenresistfolie.

(57) Die Erfindung betrifft Trockenresistzusammensetzungen auf der Grundlage von urethanisierten Umsetzungsprodukten aus 1,2-Polyepoxiden und olefinisch ungesättigten Carbonsäuren als fotopolymerisierbarem Bestandteil, üblichen Fotoinitiatoren, organischen Lösungsmitteln und ggf. üblichen Hilfsstoffen, dadurch gekennzeichnet, dass der fotopolymerisierbare Bestandteil aus einem Umsetzungsprodukt aus

a) einem Epoxyacrylat, erhalten durch Reaktion eines Diglycidylesters einer Hexahydrophthalsäure und Acryl- oder Methacrylsäure oder deren Mischungen, wobei 90 bis 100% der 1,2-Epoxidgruppen mit Methacrylsäure oder Acrylsäure verestert worden sind, und

b) Toluylendiisocyanat oder Isophorondiisocyanat, wobei zwei Grammäquivalente des Reaktionsproduktes a) mit 0,5 bis 0,9 Mol Diisocyanat zur Reaktion gebracht worden sind, besteht.

Die Erfindung betrifft ferner lagerfähige unvernetzte fotopolymerisierbare Trockenresistfolie aus obiger Zusammensetzung auf einer Kunststoffträgerfolie.

EP 0 009 216 A2

BAYER AKTIENGESELLSCHAFT 5090 Leverkusen, Bayerwerk
Zentralbereich
Patente, Marken und Lizenzen Fr/W

# Trockenfotoresistzusammensetzung und lagerfähige unvernetzte fotopolymerisierbare Trockenresistfolie

Die Erfindung betrifft durch UV-Licht vernetzbare olefinisch ungesättigte C-C-Doppelbindungen enthaltende Urethanharze für die Herstellung von Trockenresistfolien.

Vinylisch polymerisierende (d.h. Vinyl- und/oder Vinylidengruppen enthaltende) Harzsysteme, die unter der Einwirkung von UV-Licht zu lösungsmittelfesten und chemikalienbeständigen Überzügen aushärten, haben in der Vergangenheit verschiedentlich Anwendung als sogenannte Fotoresistlacke gefunden. Vorteile der durch Vinylpolymerisation vernetzbaren Fotoresistlacke sind vor allem in ihrer hohen Lichtempfindlichkeit sowie in der guten Resistenz gegenüber Ätz- und Galvanisierbädern zu suchen. Eine bevorzugte Anwendungsform dieser Systeme stellen die sogenannten Trockenresistfilme dar, bei denen das

fotopolymerisierbare Harz gemeinsam mit einem Fotoinitiator, in dünner Schicht auf eine Trägerfolie aufgebracht, in den Handel gelangt. In der Elektronikindustrie wird diese Trägerfolie mit dem fotopolymerisierbaren Harz auf die zur Herstellung von gedruckten Schaltungen vorgesehenen kupferkaschierten Basismaterialien aufkaschiert und zunächst durch die Trägerfolie in gewünschter Weise mit UV-Licht bildmäßig belichtet. Nach der Belichtung wird die Trägerfolie entfernt,und die bildmäßig partiell polymerisierte Harzschicht wird mittels Lösungsmittel oder ggf. auch mittels einer alkalischen wäßrigen Lösung entwickelt. Hierbei werden die unbelichteten Anteile der Schicht herausgewaschen, während die belichteten Anteile als Resistschicht für den nun folgenden Ätzvorgang oder etwaige Galvanisierprozesse die Kupferoberfläche schützen. Nach beendeter Ätzung bzw. Galvanisierung wird die fotopolymerisierte Harzschicht in aller Regel durch geeignete Lösungsmittel vom Träger entfernt, da sie ihre Funktion erfüllt hat.

Es ist klar, daß eine solche Technologie an die Eigenschaften der verwendeten Fotoresistsysteme höchste Anforderungen bezüglich des Eigenschaftsniveaus stellt, insbesondere dann, wenn es sich um eine Technologie handelt, die in der Praxis im breitesten Maße eingeführt ist. Das macht auch verständlich, warum nur wenige der in der Literatur erwähnten fotopolymerisierenden Harzsysteme sich für einen Einsatz als Trockenresistfilm bewährt haben. Ein solches gut funktionsfähiges

Resistsystem wird beispielsweise in der DE-OS 25 57 408 beschrieben. Es handelt sich dabei um ein carboxylgruppenhaltiges, urethanisiertes Epoxyacrylat, das nach der partiellen Belichtung durch wäßriges Alkali entwickelbar ist. Es zeichnet sich durch hohe Resistenz in allen Ätz- und sauren Galvanisierbädern aus.

Mit einem solchen Stand der Technik werden jedoch nicht alle Wünsche der Praxis voll befriedigt. Beispielsweise sind in der Praxis Galvanisierprozesse in Gebrauch, die in einem alkalischen Medium ablaufen. Es versteht sich von selbst, daß ein Carboxylgruppen tragendes Fotoresistharz, das für eine Entwicklung mit wäßrigem Alkali vorgesehen ist, solchen Bedingungen nicht standhält. Aber auch andere, mit organischen Lösungsmitteln entwickelbare Fotoresistsysteme widerstehen in aller Regel alkalischen Galvanisierbädern nur schlecht, im Gegenteil, man benutzt in der Regel wäßriges Alkali zum endgültigen Entfernen der Fotoresistschichten.

Es bestand somit die Aufgabe, ein durch Fotopolymerisation vernetzbares Harz zu entwickeln, mit dem sich Trockenresistfilme erzeugen lassen, die neben einer hohen Resistenz gegenüber sauren Ätz- und Galvanisierbädern auch in wäßrig alkalischem Medium über die notwendige Stabilität verfügen. Gleichzeitig sollte ein solches Resistharz unter praxisgemäßen Bedingungen entwickelbar sein und am Ende des üblichen Produktionsprozesses von der Kupferschicht des Basismaterials entfernbar sein.

Obwohl eine derartige Eigenschaftskombination mit den bekannten Rohstoffen für Trockenresistsysteme nicht realisierbar erschien, gelang es überraschenderweise, durch eine besondere Kombination von speziellen Epoxyacrylaten mit Diisocyanaten ein ungesättigtes Urethanharz mit olefinisch ungesättigten C-C-Doppelbindungen zu erzeugen, das bei seiner Verwendung zur Herstellung von Trockenfotoresistfilmen in vernetztem Zustand sowohl die Forderung nach Resistenz gegenüber wäßrigem Alkali erfüllt, mit einem gebräuchlichen Lösungsmittel entwickelbar ist und sich ohne Schwierigkeiten am Ende des Verarbeitungsprozesses vom Kupferträger entfernen läßt.

Gegenstand der Erfindung sind somit Zusammensetzungen für die Herstellung von Trockenfotoresistfilmen bzw. -folien auf der Grundlage von urethanisierten Umsetzungsprodukten aus 1,2-Polyepoxiden und olefinisch ungesättigten Carbonsäuren als fotopolymerisierbarem Bestandteil, üblichen Fotoinitiatoren, organischen Lösungsmitteln und ggf. üblichen Hilfsstoffen, dadurch gekennzeichnet, daß der fotopolymerisierbare Bestandteil aus einem Umsetzungsprodukt aus

a) einem Epoxyacrylat, erhalten durch Reaktion eines Diglycidylesters einer Hexahydrophthalsäure und Acryl- oder Methacrylsäure oder deren Mischungen, wobei 90 - 100 % der 1,2-Epoxidgruppen mit Methacrylsäure oder Acrylsäure verestert worden sind, und

b) Toluylendiisocyanat oder Isophorondiisocyanat, wobei zwei Grammäquivalente des Reaktionsproduktes a) mit 0,5 bis 0,9 Mol Di-Isocyanat zur Reaktion gebracht worden sind, besteht.

Epoxyacrylate im Sinne der Erfindung, d.h. Diglycidylester einer Hexahydrophthalsäure, sind literaturbekannte Anlagerungsprodukte von Acrylsäure und/oder Methacrylsäure an Hexahydrophthalsäurediglycidylester, die ggf. durch Methylgruppen substituiert sein können und Glycidylester von Umsetzungsprodukten aus 1 Mol eines Hexahydrophthalsäureanhydrids und 1/2 Mol eines Diols bzw. 1/n Mol eines Polyols mit n Hydroxylgruppen, etwa Glycidylcarbonsäureester der idealisierten Formel

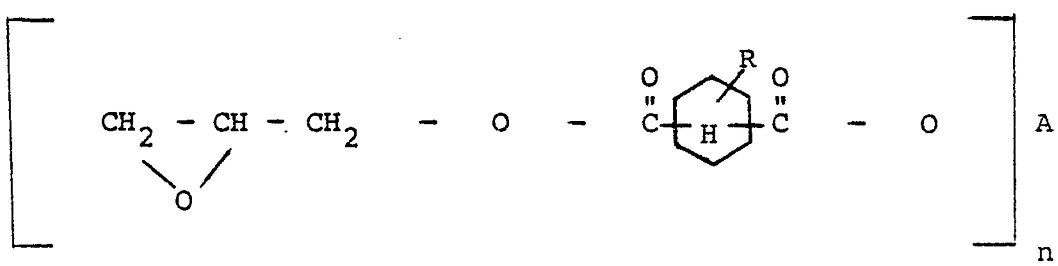

worin A einen mindestens zweiwertigen Rest eines ggf. durch Sauerstoff und/oder cycloaliphatische Ringe unterbrochenen aliphatischen Kohlenwasserstoffs oder den zweiwertigen Rest eines cycloaliphatischen Kohlenwasserstoffs, R Wasserstoff oder den Methylrest und n eine Zahl zwischen 2 - 6 bedeuten, oder Mischungen von Glycidylcarbonsäureestern der angegebenen allgemeinen Formel (vgl. britische Patentschrift 1 220 702).

Besonders bevorzugt sind als sogenannte Epoxyacrylate Umsetzungsprodukte aus Acrylsäure und/oder Methacrylsäure mit Hexahydrophthalsäurediglycidylestern mit Epoxidäquivalenten von 142 bis 200. Unter Epoxidäquivalent wird die Menge Epoxidverbindung in Gramm verstanden, in der 1 Epoxidgruppe enthalten ist.

Die Anlagerung der Acryl- und/oder Methacrylsäure an die 1,2-Polyepoxide erfolgt nach bekannten Methoden, beispielsweise nach den Verfahren der US-PS 3 301 743 oder US-PS 2 824 851 in Substanz oder in Lösungsmitteln, wie z.B. Butylacetat, Ethylacetat, Aceton, Ethylmethylketon, Diethylketon, Cyclohexan, Cyclohexanon, Cyclopentan, Cyclopentanon, n-Heptan, n-Hexan, n-Octan, Isooctan, Methylenchlorid, Chloroform, 1,1-Dichlorethan, 1,2-Dichlorethan, 1,1,2-Trichlorethan, Tetrachlorkohlenstoff. Falls gewünscht, kann die Anlagerung der (Meth)-Acrylsäure in Gegenwart von etwa 0,01 - 3 Gew.-%, bezogen auf Ausgangsepoxid, an Katalysatoren, wie tert. Amine,

Alkalihydroxide, Alkalisalze organischer Carbonsäuren, Bis-(hydroxyalkyl)sulfide, Sulfonium-, Phosphoniumverbindungen, Phosphine, Arsine oder Stibine durchgeführt werden. Als zweckmäßig haben sich Umsetzungstemperaturen von 40 - 90°C erwiesen, die jedoch in speziellen Fällen nach oben oder unten überschritten werden können. Um die resultierenden Reaktionsprodukte vor unerwünschter vorzeitiger Polymerisation zu bewahren, empfiehlt es sich, bereits bei der Herstellung 0,001 - 0,1 Gew.-%, bezogen auf die Gesamtmischung, an Polymerisationsinhibitoren zuzusetzen.

Geeignete Hilfsmittel dieser Art sind beispielsweise Phenole und Phenolderivate, vorzugsweise sterisch gehinderte Phenole, die in beiden o-Stellungen zur phenolischen Hydroxygruppe Alkylsubstituenten mit 1 - 6 C-Atomen enthalten, Amine, vorzugsweise sekundäre Arylamine und ihre Derivate, Chinone, Kupfer-I-Salze organischer Säuren oder Anlagerungsverbindungen von Kupfer(I)-halogeniden an Phosphite.

Namentlich seien genannt: 4,4'-Bis-(2,6-di-tert.-butylphenol), 1,3,5-Trimethyl-2,4,6-tris-(3,5-di-tert.-butyl-4-hydroxy-benzyl)-benzol, 4,4'-Butyliden-bis-(6-tert.-butyl-m-kresol), 3,5-Di-tert.-butyl-4-hydroxybenzylphosphonsäurediethylester, N,N'-Bis-(ß-naphthyl)-p-phenylendiamin, N,N'-Bis-(1-methylheptyl)-p-phenylendiamin, Phenyl-ß-naphthylamin, 4,4'-Bis-(α,α-dimethylbenzyl)-diphenylamin, 1,3,5-Tris-(3,5-di-tert.-butyl-4-hydroxy-hydrocinnamoyl)-hexahydro-s-triazin, Hydrochinon,

p-Benzochinon, 2,5-Di-tert.-butylchinon, Toluhydrochinon, p-tert.-Butylbenzcatechin, 3-Methyl-brenzcatechin, 4-Ethylbrenzcatechin, Chloranil, Napthochinon, Kupfernaphthenat, Kupferoctoat, Cu(I)Cl/Triphenylphosphit,Cu-(I)-Cl/Trimethylphosphit, Cu(I)Cl/Trichlorethyl -phosphit, Cu(I)Cl/Tripropylphosphit, p-Nitrosodimethylanilin.

Weitere geeignete Stabilisatoren sind in "Methoden der organischen Chemie" (Houben-Weyl), 4. Auflage, Band XIV/1, S. 433 - 452, 756, Georg Thieme Verlag, Stuttgart, 1961, beschrieben. Sehr gut geeignet ist z.B. p-Benzochinon und/oder Hydrochinonmonomethylether in einer Konzentration von 0,001 - 0,05 Gew.-%, bezogen auf Gesamtmischung.

Die so erhaltenen Umsetzungsprodukte aus den aufgeführten Diglycidylestern und Acryl- und/oder Methacrylsäure stellen ß-Hydroxylalkylester dar, die in den angegebenen Mengenverhältnissen mit 2,4- oder 2,6-Toluylendiisocyanat oder deren Gemische oder Phorondiisocyanat umgesetzt werden.

Bevorzugt ist die Verwendung von Isophorondiisocyanat (1-Isocyanatomethyl-5-Isocyanato-1,3,3-Trimethyl-Cyclohexan). Bei der Umsetzung der sogenannten Epoxyacrylate mit den Diisocyanaten, die sowohl in Substanz, zweckmäßigerweise jedoch in einem Lösungsmittel, wie es auch bei der Umsetzung des Glycidylesters mit (Meth)Acrylsäure zugegen sein kann, durchgeführt werden kann, erhält man, falls gewünscht, unter Mitverwendung von

Katalysatoren, Urethangruppen-haltige Harze oder Harzlösungen.

Als mitzuverwendende Katalysatoren kommen solche der an sich bekannten Art in Frage, z.B. tert. Amine, wie Triethylamin, Tributylamin, N-Methyl-morpholin, N-Ethylmorpholin, N-Cocomorpholin, N,N,N',N'-Tetramethylethylendiamin, 1,4-Diaza-bicyclo-(2,2,2)-octan, N-Methyl-N'-dimethylaminoethyl-piperazin, N,N-Dimethylbenzylamin, Bis-(N,N-diethylaminoethyl)-adipat, N,N-Diethylbenzylamin, Pentamethyldiethylentriamin, N,N-Dimethylcyclohexylamin, N,N,N',N'-Tetramethyl-1,3-butandiamin, N,N-Dimethyl-ß-phenylethylamin, 1,2-Dimethylimidazol, 2-Methylimidazol. Als Katalysatoren kommen auch an sich bekannte Mannichbasen aus sekundären Aminen, wie Dimethylamin, und Aldehyden, vorzugsweise Formaldehyd, oder Ketonen wie Aceton, Methylethylketon, Cyclohexanon und Phenolen, wie Phenol, Nonylphenol, Bisphenol in Frage.

Gegenüber Isocyanatgruppen aktive Wasserstoffatome aufweisende tertiäre Amine als Katalysatoren sind z.B. Triethanolamin, Triisopropanolamin, N-Methyldiethanolamin, N-Ethyldiethanolamin, N,N-Dimethyl-ethanolamin, sowie deren Umsetzungsprodukte mit Alkylenoxiden, wie Propylenoxid und/oder Ethylenoxid.

Als Katalysatoren kommen ferner Silaamine mit Kohlenstoff-Silizium-Bindungen, wie sie z.B. in der DE-PS

1 229 290 (entsprechend der US-PS 3 620 984) beschrieben sind, in Frage, z.B. 2,2,4-Trimethyl-2-silamorpholin, 1,3-Diethylaminomethyl-tetramethyl-disiloxan.

Als Katalysatoren kommen auch stickstoffhaltige Basen wie Tetraalkylammoniumhydroxide, ferner Alkalihydroxide wie Natriumhydroxid, Alkaliphenolate wie Natriumphenolat oder Alkalialkoholate wie Natriummethylat in Betracht. Auch Hexahydrotriazine können als Katalysatoren eingesetzt werden.

Ferner können auch organische Metallverbindungen, insbesondere organische Zinnverbindungen, als Katalysatoren verwendet werden.

Als organische Zinnverbindungen kommen vorzugsweise Zinn(II)-salze von Carbonsäuren wie Zinn(II)-acetat, Zinn(II)-octoat, Zinn(II)-ethylhexoat und Zinn(II)-laurat und die Zinn(IV)-Verbindungen, z.B. Dibutylzinnoxid, Dibutylzinndichlorid, Dibutylzinndiacetat, Dibutylzinndilaurat, Dibutylzinnmaleat oder Dioctylzinndiacetat in Betracht. Selbstverständlich können alle obengenannten Katalysatoren als Gemische eingesetzt werden.

Weitere Vertreter von erfindungsgemäß zu verwendenden Katalysatoren sowie Einzelheiten über die Wirkungsweise der Katalysatoren sind im Kunststoff-Handbuch, Band VII, herausgegeben von Vieweg und Höchteln, Carl-Hanser-Verlag, München, 1966, z.B. auf den Seiten 96 - 102 beschrieben.

Die Katalysatoren werden in der Regel in einer Menge zwischen ca. 0,001 und 10 Gew.-%, bezogen auf die Gewichtsmenge an Isocyanat + Umsetzungsprodukt aus 1,2-Polyepoxid und (Meth)Acrylsäure (= Epoxyacrylat), eingesetzt.

Bei der Umsetzung der Epoxyacrylate mit Diisocyanaten ist grundsätzlich eine Hydroxylgruppe einer Isocyanatgruppe äquivalent. Zwei Grammäquivalente des Epoxyacrylats können mit 0,5 Mol Diisocyanat bis 0,9 Mol Diisocyanat zur Reaktion gebracht werden. Besonders bevorzugt sind jedoch Umsetzungsprodukte, bei denen auf zwei Grammäquivalente des Epoxyacrylats 0,66 bis 0,86 Mol Diisocyanat entfallen. Unter einem Grammäquivalent des Epoxyacrylats wird die Menge Epoxyacrylat in Gramm verstanden, die sich aus der Umsetzung von 1 Grammäquivalent Epoxid des Glycidylesters (=Epoxidäquivalent) mit 1 Grammäquivalent (= 1 Mol) Acryl- bzw.Methacrylsäure ergibt. Die zur Herstellung der Epoxyacrylate eingesetzten Glycidylester sind reine bzw. technische Produkte und stets durch das Epoxidäquivalent definiert.

Bei den verwendeten Epoxyacrylaten kann es sich um stöchiometrische Umsetzungsprodukte aus 2 Epoxidäquivalenten Bisglycidylester und 2 Mol Acryl- bzw. Methacrylsäure handeln. Es können jedoch auch teilweise mit den

ungesättigten Carbonsäuren umgesetzte Glycidylester, die noch freie Epoxygruppen enthalten, zu ungesättigten Urethanharzen umgesetzt werden. Bevorzugt finden Epoxyacrylate Verwendung, bei denen mindestens 90 - 100 % der ursprünglich vorhandenen Epoxygruppen mit Acryl- und/oder Methacrylsäure zur Reaktion gebracht worden sind.

Die Urethanisierung wird zweckmäßigerweise bei Temperaturen zwischen 40 und 80°C durchgeführt; das Ende dieser Reaktion kann durch analytische Methoden des Isocyanatnachweises kontrolliert werden.

Nach dieser Umsetzung resultiert schließlich ein klares Harz oder eine Harzlösung, je nachdem, ob bei diesem Reaktionsablauf ein Lösungsmittel mit vorhanden war oder nicht. Zum endgültigen Einsatz als Rohstoff für einen Fotoresistlack oder für eine Fotopolymerdruckplatte werden dem Harz noch ein oder mehrere Fotoinitiatoren zugesetzt.

Als Fotoinitiatoren sind die üblicherweise eingesetzten Verbindungen geeignet, beispielsweise Benzophenon sowie ganz allgemein aromatische Ketonverbindungen, die sich vom Benzophenon ableiten, wie Alkylbenzophenone, halogenmethylierte Benzophenone gemäß der Deutschen Offenlegungsschrift 1 949 010, Michlers Keton, Anthron, halogenierte Benzophenone. Ferner eignen sich Benzoin und seine Derivate, etwa gemäß den Deutschen Offenlegungsschriften 1 769 168, 1 769 853, 1 769 854, 1 807 297, 1 807 301, 1 919 678 und der Deutschen Auslegeschrift 1 694 149. Ebenfalls wirksame Fotoinitiatoren stellen Anthrachinon und zahlreiche seiner Derivate dar, beispielsweise ß-Methylanthrachinon, tert. Butylanthrachinon und Anthrachinoncarbonsäureester, ebenso Oximester gemäß der Deutschen Offenlegungsschrift 1 795 089.

Geeignet sind als Fotoinitiatoren auch Benzoinderivate der allgemeinen Formel

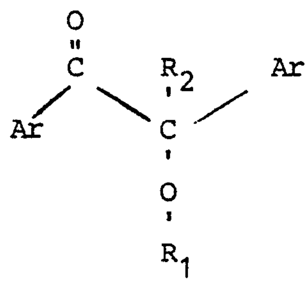

worin Ar ein unsubstituierter oder mit Alkyl, Alkoxy, Halogen substituierter aromatischer Rest,

$R_1$ = geradkettiger oder verzweigter Alkylrest mit ($C_1$ - $C_{12}$), Cycloalkyl wie Cyclohexyl, Tetrahydropyranyl, 1-Methoxyethyl,

$R_2$ = Allyl, Benzyl, ggf. durch Halogen subst., oder der Rest $-CH_2-CH_2-x$, wobei x = CN, $CONH_2$, $COOR_3$ und

$R_3$ = H, nieder Alkyl ($C_1$ - $C_{10}$)

ist.

Vorzugsweise bedeuten Ar = Phenyl, $R_1$ einen geradkettigen oder verzweigten Alkylrest mit 1 - 4 C-Atomen und $R_2$ = Alkyl oder den Rest $-CH_2-CH_2-X$ mit X = CN und $COOR_3$, wobei $R_3$ = $C_1$ - $C_4$ Alkyl ist.

Geeignete Verbindungen dieses Typs (vgl. Deutsche Offenlegungsschrift 1 769 854) sind beispielsweise die folgenden:

α-Allylbenzoinmethylether, α-Allylbenzoinisopropylether, α-Allylbenzoinethylether, α-Allylbenzoinbutylether, α-Allylbenzoinpropylether, Allylbenzoinoctylether, Allylbenzoindodecylether, α-Benzylbenzoinmethylether, α-Benzylbenzoinethylether, α-Benzylbenzoinpropylether, α-Benzylbenzoinisopropylether, α-Benzylbenzoinbutylether, α-(2-Cyanethyl)-benzoinmethylether, α-(2-Cyanethyl)-benzoinethylether, α-(2-Cyanethyl)-benzoinpropylether, α-(2-Cyanethyl)-benzoinisopropylether, α-(2-Cyanethyl)-benzoinbutylether, α-(2-Cyanethyl)-benzoinisobutylether, α-(2-Cyanethyl)-benzoinhexylether, α-(2-Cyanethyl)-benzoinoctylether, α-(2-Cyanethyl)-benzoindodecylether, α-(2-Cyanethyl)-benzoinisooctylether, α-(2-Carboxyethyl)-benzoinmethylether, α-(2-Carboxyethyl)-benzoinethylether, α-(2-Carboxyethyl)-benzoinpropylether, α-(2-Carboxyethyl)-benzoinisopropylether, α-(2-Carboxyethyl)-benzoinbuthylether, α-(2-Carboxyethyl)-benzoinisobutylether, α-(2-Carboxyethyl)-benzoinhexylether, α-(2-Carboxyethyl)-benzoinoctylether, α-(2-Carboxyethyl)-benzoindodecylether, α-(2-Carboxyethyl)-benzoinisooctylether, α-(2-Carbomethoxyethyl)-benzoinmethylether, α-(2-Carbomethoxyethyl)-benzoinethylether, α-(2-Carbomethoxyethyl)-benzoinpropylether α-(2-Carbomethoxyethyl)-benzoinisopropylether, α-(2-Carbomethoxyethyl)-benzoinbutyl-

ether, -(2-Carbomethoxyethyl)-benzoinisobutylether, α-(2-Carbomethoxyethyl)-benzoinhexylether,α-(2-Carbomethoxyethyl)-benzoinoctylether,α-(2-Carbomethoxyethyl)-benzoindodecylether, -(2-Carbomethoxyethyl)-benzoinisooctylether, -(2-Carboethoxyethyl)-benzoinmethylether, α-(2-Carboethoxyethyl)-benzoinethylether,α-(2-Carboethoxyethyl)-benzoinpropylether,α-(2-Carboethoxyethyl)-benzoinisopropylether,α-(2-Carboethoxyethyl)-benzoinbutylether,α-(2-Carboethoxyethyl)-benzoinisobutylether, α-(2-Carboethoxyethyl)-benzoinhexylether,α-(2-Carboethoxyethyl)-benzoinoctylether,α-(2-Carboethoxyethyl)-benzoindodecylether,α-(2-Carboethoxyethyl)-benzoinisooctylether, α-(2-Carboprooxyethyl)-benzoinmethylether,α-(2-Carbopropoxyethyl)-benzoinethylether,α-(2-Carbopropoxyethyl)-benzoinpropylether,α-(2-Carbopropoxyethyl)-benzoinisopropylether,α-(2-Carbopropoxyethyl)-benzoinbutylether, α-(2-Carbopropoxyethyl)-benzoinisobutylether,α-(2-Carbopropoxyethyl)-benzoinhexylether,α-(2-Carbopropoxyethyl)-benzoinoctylether,α-(2-Carbopropoxyethyl)-benzoindodecylether,α-(2-Carbopropoxylethyl)-benzoinisooctylether, α-(2-Carbo-n-butoxyethyl)-benzoinmethylether,α-(2-Carbo-n-butoxyethyl)-benzoinethylether,α-(2-Carbo-n-butoxyethyl)-benzoinpropylether,α-(2-Carbo-n-butoxyethyl)-benzoinisopropylether,α-(2-Carbo-n-butoxyethyl)-benzoinbutylether, α-(2-Carbo-n-butoxyethyl)-benzoinisobutylether,α-(2-Carbo-n-butoxyethyl)-benzoinhexylether, α-(2-Carbo-n-butoxyethyl)-benzoinoctylether,α-(2-Carbo-n-butoxyethyl)-benzoindodecylether,α-(2-Carbo-n-butoxyethyl)-benzoinisooctylether,α-(2-Carboisooctoxyethyl)-benzoinmethylether,

α-(2-Carboisooctoxyethyl)-benzoinethylether, α-(2-Carboisooctoxyethyl)-benzoinpropylether, α-(2-Carboisooctoxyethyl)-benzoinisopropylether, α-(2-Carboisooctoxyethyl)-benzoinbutylether, α-(2-Carboisooctoxyethyl)-benzoinisobutylether, α-(2-Carboisooctoxyethyl)-benzoinoctylether, α-(2-Carboisooctoxyethyl)-benzoindodecylether, α-(2-Carboisooctoxyethyl)-benzoinisooctylether, α-(2-Carbonamidoethyl)-benzoinmethylether, α-(2-Cyanethyl)-benzointetrahydropyranylether, α-(2-Cyanethyl)-benzoin-(1-methoxyethylether, α-(2-Carbomethoxyethyl)-benzointetrahydropyranylether, α-(2-Carbethoxyethyl)-benzoin-(1-methoxyethylether), α-(2-Carbo-n-butoxyethyl)-benzointetrahydropyranylether, α-(2-Carboisooctoxyethyl)-benzointetrahydropyranylether.

Weitere, im erfindungsgemäßen Harzsystem einsetzbare Fotoinitiatoren sind das Benzildimethylketal und ähnliche Derivate des Benzils.

Die Fotoinitiatoren werden in Mengen zwischen 0,05 und 8 Gew.-%, vorzugsweise 0,5 und 5 Gew.-%, bezogen auf fotopolymerisierbaren, lösungsmittelfreien Bestandteil des Harzes zugesetzt.

Die erfindungsgemäßen Zusammensetzungen (Mischungen) enthalten die urethanisierten Epoxyacrylate, organische Lösungsmittel, mindestens einen üblichen Fotoinitiator und ggf. übliche Hilfsstoffe. Die Trockenresistfolie selbst enthält die erfindungsgemäßen Zusammensetzungen

natürlich in lösungsmittelfreier Form.

Die organischen Lösungsmittel sind die gleichen, wie sie bei der Umsetzung des Glycidylesters mit (Meth)Acrylsäure verwendet werden. Die Menge des eingesetzten Lösungsmittels kann in weiten Bereichen variieren. Wesentlich ist lediglich, daß aus der Lösung ein Film hergestellt werden kann. Bevorzugt werden die Lösungsmittel, bezogen auf fotopolymerisierbare Festsubstanz (=urethanisiertes Epoxyacrylat) + Fotoinitiator, in Mengen von etwa 40 - 400 Gew.-% eingesetzt.Der Fotoinitiatoranteil beträgt, bezogen auf fotopolymerisierbare Festsubstanz, 0,05 bis 8 Gew.-%. Gegebenenfalls übliche Hilfsstoffe sind Weichmacher, Verlaufsmittel, Farbstoffe oder andere Füllmaterialien, die im Spektralbereich des die Fotopolymerisation initiierenden Lichtes gar nicht oder möglichst wenig absorbieren, und inerte Polymere. Die Menge an Hilfsmitteln kann, bezogen auf fotopolymerisierbare Festsubstanz,etwa bis zu 30 Gew.-% betragen.

Die erfindungsgemäße Zusammensetzung wird durch Tauchen, Sprühen, Gießen, Walzen, Schleudern oder durch ein sonstiges gebräuchliches Auftragsverfahren auf eine Kunststoffträgerfolie, vorzugsweise eine Polyesterfolie, in einer Dicke aufgebracht, daß nach dem Abdampfen des Lösungsmittels, das ggf. bei erhöhter Temperatur bis ca. 80°C erfolgen kann, ein etwa 5-100 μm dicker Film erzeugt wird. Die trockene, noch unvernetzte Schicht kann durch

Aufwalzen einer weiteren Folie (Abdeckfolie), beispielsweise aus Polyethylen oder Polypropylen, geschützt und anschließend unter Lichtausschluß bis zum eigentlichen Verbrauch gelagert werden.

Als Kunststoffträgerfolie können auch Folien aus Polyamiden, Polycarbonaten, Polyhydantoinen, Polyarylenoxiden, Polysulfonen usw. verwendet werden. Die Dicke der Kunststoffträgerfolie beträgt etwa 5 - 100 $\mu$. Die Abdeckfolien haben eine Dicke von etwa 10 - 50 $\mu$.

Die trockene Schicht der erfindungsgemäßen Zusammensetzungen auf der Trägerfolie stellt den eigentlichen Trockenfilmresist dar. Mit geeigneten Kaschiervorrichtungen kann dieser bei erhöhter Temperatur nach Entfernen der Abdeckfolie auf die in der Elektronikindustrie üblichen kupferbeschichteten Trägermaterialien (Schichtträger) auflaminiert werden.

Geeignete Schichtträger, auf die der Trockenfilmresist aufkaschiert werden kann, sind aber auch Metallfolien aus Aluminium, Zink, Magnesium, Stahl u.dgl., ferner Papier, Glas oder Folien aus polymeren Produkten, wie Celluloseestern, Polyvinylacetat, Polystyrol, Polycarbonaten, insbesondere auf der Basis von Bisphenylolalkanen, Polyestern, insbesondere auf Basis Polyethylenterephthalat, Polyamiden, wie beispielsweise Nylon. Als Unterlage sind ferner Materialien mit netzförmiger Struktur, wie Metallnetze, geeignet.

Die Belichtung der fotopolymerisierbaren Schichten erfolgt mit den in der Reproduktionstechnik gebräuchlichen Lichtquellen, wie Kohlebogenlampen, Xenonlampen, UV-Fluorescenzlampen, Quecksilberniederdrucklampen, Quecksilberhochdrucklampen, die neben sichtbarem Licht einen für die Polymerisation besonders wirksamen Anteil an ultraviolettem Licht liefern.

An den belichteten Stellen ist der Trockenresistfilm vernetzt und unlöslich. Man erhält nach Entfernen der Kunststoffträgerfolie (Abziehen) bei der Entwicklung mit vorzugsweise chlorierten Kohlenwasserstoffen, wie Perchlorethan und Trichlorethylen, ggf. auch mit anderen Lösungsmitteln wie Alkoholen, Ketonen, Estern oder aromatischen Kohlenwasserstoffen, ein Relief in Form der bildmäßigen Belichtung.

Der Trockenresistfilm zeichnet sich nach Belichtung und Entwicklung durch besondere mechanische Festigkeit und besondere Haftung auf metallischen Trägermaterialien aus. Dieses macht ihn besonders geeignet für die Anwendung in den gebräuchlichen Ätzlösungen wie verdünnter Salpetersäure und Eisen-III-Chlorid-Lösung sowie in den gebräuchlichen Bädern zur Metallabscheidung. Besonders hervorzuheben ist, daß er auch in alkalischen Bädern stabil ist. Wichtiger Anwendungszweck der erfindungsgemäßen Schichten ist der Einsatz als Trockenfotoresist für die Herstellung von gedruckten Schaltungen, die Herstellung von geätzten Formteilen, die Herstellung von

Formteilen nach dem Elektroforming-Verfahren und die Herstellung von integrierten Mikroschaltkreisen.

Die hohe mechanische Festigkeit und Härte der erfindungsgemäßen lichtvernetzbaren Schichten ermöglicht aber auch eine Anwendung als Druckform im Hochdruck, eine Anwendung bei der Herstellung von Tief- oder Flachdruckformen, insbesondere aber auch die Herstellung von Siebdruckschablonen.

Besonders hervorzuheben ist, daß sich auch der vernetzte Film da, wo erforderlich, durch ein geeignetes Lösungsmittelgemisch leicht entfernen läßt. So ist es möglich, mit einer Lösung aus gleichen Teilen n-Butanol, Ethanolamin und Wasser vernetzte Filme bei einer leicht erhöhten Temperatur innerhalb weniger Minuten von jedem beliebigen Träger abzulösen.

Die hohe Härte der polymerisierten Harze erlaubt auch den Vorgang der Abmaterung. Hierzu wird mit dem erfindungsgemäßen Harzmaterial auf einem geeigneten Träger eine Schicht erzeugt, die in der Dicke der Profiltiefe einer üblichen Hochdruckplatte entspricht. Nach Belichtung und Entwicklung, beispielsweise in Trichlorethylen, kann das erhaltene Relief unmittelbar mit den praxisüblichen Materialien abgematert werden. Selbstverständlich ist auch ein direkter Einsatz als Druckplatte möglich.

Bei diesem Einsatzzweck ist auch die Mitverwendung von

bestimmten Füllstoffen in den mit dem erfindungsgemäßen Harz erzeugten Schichten möglich. Insbesondere erfordert die Ausbildung eines für den Druckvorgang geeigneten Rasters eine bestimmte Streuung des zur Polymerisation der Schicht benutzten Lichtes. Dieses kann durch geeignete Zusätze erreicht werden.

Die Vernetzungsreaktion ist nicht allein durch Licht auslösbar: Andere energiereiche Strahlen wie Elektronen-, Röntgen- und z.B. $\gamma$-Strahlen können ebenfalls herangezogen werden.

Die fotopolymerisierbaren Bestandteile der beanspruchten Zusammensetzungen für die Herstellung von Trockenfotoresistfilmen bzw. -folien sind unter anderem als Zwischenprodukte für Resistmaterialien in der bereits eingangs erwähnten DE-OS 25 57 408 beschrieben, wo sie mit cyclischen Dicarbonsäureanhydriden umgesetzt werden, um saure Halbestergruppierungen in den Molekülen zu erzeugen. Dadurch wurde einmal erreicht, daß die auf Trägermaterialien aufgebrachten, partiell belichteten Filme durch wäßriges Alkali entwickelbar sind. Zum anderen wurde damit die Haftfestigkeit des vernetzten Films auf dem Trägermaterial verbessert und eine hohe Resistenz in sauren Galvanisierbädern erreicht. Die eingangs erwähnte Aufgabe der vorliegenden Erfindung konnte nicht dadurch gelöst werden, daß lediglich auf die Umsetzung mit cyclischem Dicarbonsäureanhydrid verzichtet wurde, denn die meisten der in der DE-OS 25 57 408 beschriebenen urethanisierten, nicht mit Dicarbonsäureanhydrid umgesetzten Epoxyacrylate sind als Trockenfotoresistmaterialien ungeeignet. Es müßte vielmehr eine ganz spezielle Auswahl bezüglich der einzusetzenden Epoxidtypen und Polyisocyanate getroffen werden, die nicht vorhersehbar war. Selbst so nah verwandte Verbindungen wie Phthalsäure- und Terephthalsäurediglycidester, umgesetzt mit (Meth)Acrylsäure und anschließend urethanisiert, waren nicht als Trockenresistmaterial geeignet, wie aus den Vergleichsversuchen hervorgeht. Und auch bezüglich der Isocyanatkomponenten mußte eine ganz spezielle Auswahl getroffen werden.-

Im nachfolgenden sei durch Beispiele die Herstellung der erfindungsgemäßen Fotopolymeren und ihre Anwendung näher erläutert. Die Prozentangaben beziehen sich auf das Gewicht.

Ausgangskomponente 1

1843 g (9,7 Grammäquivalente Epoxid = 9,7 Epoxidäquivalente) eines Hexahydrophthalsäurebisglycidylesters (Epoxidäquivalent = 190), 13 g (0,5 %) Thiodiglykol und 0,53 g (0,02 %) p-Methoxyphenol wurden in einem 3-l-Dreihalskolben mit Rührer, Tropftrichter und Rückflußkühler auf 60°C erhitzt. Nun wurden unter Luftdurchleiten während 3 Std. 698 g (9,7 Mol) Acrylsäure zugetropft. Die Temperatur der Mischung wurde auf 80°C erhöht, und nach 48 Std. Rühren zeigte eine konstant bleibende Säurezahl von 1,8 das Ende der Reaktion an. Das Harz wurde auf Raumtemperatur abgekühlt.

Ausgangskomponente 2

Analog dem Verfahren für Komponente 1 wurden 1843 g (9,7 Epoxidäquivalente) Hexahydrophthalsäurebisglycidylester (Epoxidäquivalent 190), 0,53 g(0,02 %) p-Methoxyphenol und 13 g (0,5 %) Thiodiglykol mit 834 g (9,7 Mol) Methacrylsäure zur Reaktion gebracht. Nach 56 Std. hatte die Mischung eine konstante Säurezahl von 2,6 erreicht und wurde auf Raumtemperatur abgekühlt.

Beispiel 1

209,6 g (0,8 Grammäquivalente) des Epoxyacrylats (Ausgangskomponente 1) wurden mit 141 g Methylenchlorid, 0,42 g Diazobicyclooctan und weiteren 0,05 g (0,02 %) p-Methoxyphenol versetzt. Diese Lösung wurde in einem 500-ml-Rundkolben mit Rührer und Rückflußkühler bei einer Temperatur von 35°C während 2 Std. unter Luftdurchleiten mit 52,2 g (0,3 Mol) Toluylendiisocyanat zur Reaktion gebracht. Nach einer Reaktionszeit von weiteren 8 Std. ließ sich ein NCO-Gehalt von 0,21 % nachweisen. Der Harzlösung wurden als Fotoinitiator 10 g (4 %) Benzophenon hinzugefügt.

Beispiel 2

Analog Beispiel 1 wurden 262 g = 10 Grammäquivalente des Epoxyacrylates (=Ausgangskomponente 1) in 178 g Methylenchlorid mit 0,53 g (0,16 %) Diazabicyclooctan und 0,07 g (0,02 %) p-Methoxyphenol vermischt und mit 69,6 g (0,4 Mol)

Toluylendiisocyanat zur Reaktion gebracht. Nach einer gesamten Reaktionszeit von 10 Std. betrug der NCO-Gehalt 0,26 %. Als Fotoinitiator 16,5 g Benzildimethylketal zugesetzt.

Beispiel 3

Analog Beispiel 1 wurden 104,8 g = 0,4 Grammäquivalente der Ausgangskomponente 1 (Epoxyacrylat) in 74 g Methylenchlorid mit 0,22 g (0,22 g (0,16 %) Diazabicyclooctan (als 10 %ige Lösung in Methylglykolacetat) und 0,03 g (0,02 %) p-Methoxyphenol vermischt. Diese Lösung wurde mit 33,3 g (0,15 Mol) Isophorondiisocyanat zur Reaktion gebracht. Nach einer Gesamtreaktionszeit von 11 Std. wurde ein NCO-Gehalt von 0,32 % bestimmt. Als Fotoinitiator wurden 6,9 g ß-(Cyanethyl)Benzoinethylether hinzugefügt.

Beispiel 4

In einer Eintopfreaktion wurden 1900 g (10 Grammäquivalente Epoxid) Hexahydrophthalsäurebisglycidylester (Epoxid äquivalent = 190), 131 g (0,5 %) Thiodiglykol und 0,53 g (0,02 %) p-Methoxyphenol in der bei der Herstellung der Ausgangskomponente 1 beschriebenen Weise mit 720 g (10 Mol) Acrylsäure umgesetzt und nach beendeter Reaktion mit 1889 g Methylenchlorid verdünnt. Hinzugefügt wurden 5,6 g Diazabicyclooctan (als 10 %ige Lösung in Methylglykolacetat) und 0,7 g (0,02 %) p-Methoxyphenol. Dieses Gemisch wurde in der in Beispiel 1 beschriebenen Weise mit 888 g (4 Mol) Isophorondiisocyanat zur Reaktion

gebracht. Nach einer Reaktionszeit von 20 Std. ließ sich ein NCO-Gehalt von 0,13 % nachweisen. Die Harzlösung hatte einen Feststoffgehalt von 69,5 %. Durch Hinzufügen von 253 g Methylglykolacetat, 140 g Benzophenon und weiteren 0,36 g p-Methoxyphenol wurde eine zur Herstellung von Trockenresistfilmen geeignete Gebrauchslösung mit einem Festgehalt von 68,4 % erhalten.

Beispiel 5

2760 g (=Grammäquivalente) des Umsetzungsproduktes aus Hexahydrophthalsäurebisglycidylester und Methacrylsäure (Ausgangskomponente 2), gelöst in 1964 g Methylenchlorid, vermischt mit 5,8 g Diazabicyclooctan (10 %ig) in Methylglykolacetat) und 0,7 g p-Methoxyphenol wurde ebenfalls mit 888 g (4,0 Mol) Isophorondiisocyanat in der in Beispiel 4 beschriebenen Weise zur Reaktion gebracht. Nach 24 Std. wurde auch hier eine Harzlösung mit einem NCO-Gehalt von 0,13 % erhalten, die zur Herstellung einer Trockenresistfolie noch mit 140 g Benzophenon versetzt wurde.

Anwendungsbeispiele

Beispiel 6

43 g der Harzlösung aus Beispiel 4 wurden mit 43 g Methylglykolacetat verdünnt und mit einer Lösung aus 0,15 g (0,5 %) Michlers-Keton und 0,06 g (0,2 %) eines roten Farbstoffes (Colour Index 1956 Volume 3 Basic Red 1

No. 45160) in 10 g Methylenchlorid und 4 g Methylglykolacetat vermischt. Die resultierende Lösung mit einem Festgehalt von 30 % wurde aus einer Tauchschale mit 0,5 m/min auf eine 36 /u starke Polyesterfolie aufgezogen. Nach dem Trocknen in 80°C warmer Luft erhielt man auf der Folie eine Schicht von 60/u Dicke. Diese ließ sich auf eine saubere Kupferfolie bei 90°C thermisch übertragen. Nach bildmäßiger Belichtung durch einen 0,15 Graustufenkeil (2 min in einem Chem-Cut-Rahmen,= Flachvakuumbelichtungsrahmen) wurde nach Entfernen der Polyesterfolie in Trichlorethylen entwickelt. Nach einer Entwicklungszeit von 20 s resultierte ein sehr widerstandsfähiges, hartes Relief von 12 Stufen des Testkeils auf der Kupferfolie, das einen Ätzvorgang mit verdünnter $HNO_3$ unverändert überstand.

Beispiel 7

Die beschichtete Polyesterfolie aus Beispiel 6. wurde mit einer Polyethylenfolie abgedeckt und konnte in dieser Form während 2 Monaten bei 60°C gelagert werden. Nach dieser Zeit war ein thermisches Aufkaschieren auf eine Kupferplatte noch problemlos möglich. Eine 2-minütige Belichtung im Chem-Cut-Rahmen und eine Entwicklung mit Perchlorethan oder Trichlorethylen lieferte ein festes, gut haftendes Relief.

Beispiel 8

Wird die gemäß Beispiel 6 mit dem lichtempfindlichen Harz beschichtete Polyethylenterephthalatfolie nach dem Trocknen auf Kupfer-Pertinax kaschiert, dieses Material,wie bereits erwähnt,bildmäßig belichtet und nach dem Abziehen der Polyethylenterephthalatfolie mit Trichlorethylen entwickelt, so erhält man auf dem Kupfer eine Beschichtung, die gegen alle sauren Ätzmedien praktisch unbegrenzt haltbar ist, und die auch gegenüber $30^{o}C$ warmer 1-n-Natronlauge mindestens 2 Std. stabil ist. Nach einem üblichen Ätzvorgang oder nach einer Galvanisierung läßt sich die vernetzte Fotopolymerschicht in einer Lösung aus gleichen Teilen n-Butanol, Ethanolamin und Wasser bei einer Temperatur von $30^{o}C$ innerhalb von 2 - 3 min ablösen.

Vergleichsbeispiel 1

210 g Terephthalsäurebisglycidylester (Epoxidäquivalent = 210), 1,4 g (0,5 %) Thiodiglykol und 0,06 g (0,02 %) p-Methoxyphenol wurden in der üblichen Weise mit 72 g (1 Mol) Acrylsäure umgesetzt und nach beendeter Reaktion mit 200 g Methylenchlorid verdünnt. Hinzugegeben wurden 0,5 g Diazabicyclooctan (als 10 %ige Lösung in Methylglykolacetat) und weitere 0,07 g (0,02 %) p-Methoxyphenol. Diese Lösung wurde

in der in Beispiel 1 beschriebenen Weise mit 88 g (0,4 Mol) Isophorondiisocyanat zur Umsetzung gebracht. Nach einer Reaktionszeit von 18 Stunden ließ sich ein NCO-Gehalt von 0,11 % nachweisen. Durch Zugabe von 14,8 g Benzophenon, 3,7 g Michlers-Keton, weiteren 0,04 g p-Methoxyphenol sowie 50 ml Methylglykolacetat wurde eine Harzlösung erhalten, die sich analog Beispiel 6 zu einer Trockenresistfolie verarbeiten ließ und auf eine saubere Kupferoberfläche übertragen wurde. Es wurde in der in Beispiel 6 beschriebenen Weise belichtet und die Polyesterfolie entfernt.

Die resultierende Polymerschicht konnte nicht mit Trichloräthylen oder Perchloräthan entwickelt werden. Eine Entwicklung, bei der auch belichtete Anteile der Schicht erweicht wurden, gelang mit Methyläthylketon. Bei einer Knickprobe des auf dem Kupfer verbliebenen Polymerfilms trat eine teilweise Ablösung der Schicht ein.

Eine entsprechende Knickprobe bestand die Resistschicht gemäß Beispiel 6 unbeanstandet.

Vergleichsbeispiel 2

Analog Vergleichsbeispiel 1 wurde aus 210 g Terephthalsäurebisglycidylester, 72 g Acrylsäure und 69 g Toluylendiisocyanat ein Resistlach hergestellt und in der dort beschriebenen Weise formuliert und geprüft.

Auch in diesem Falle war eine Entwicklung mit den praxisüblichen Lösungsmitteln Trichloräthylen oder Perchloräthan nicht möglich. Eine Entwicklung gelang mit einem Gemisch aus 3 Teilen Trichloräthylen und 1 Teil Äthanol. Bei einer Knickprobe des trockenen, auf dem Kupfer verbliebenen Polymerfilms erwies sich dieser als sehr spröde und brüchig.

Vergleichsbeispiel 3

Analog Vergleichsbeispiel 1 wurden 186 g Phthalsäurebisglycidylester (Epoxidäquivalent = 186) in Gegenwart von 1,3 g (0,5 %) Thiodiglykol und 0,05 g (0,02 %) p-Methoxyphenol mit 72 g Acrylsäure abreagiert und anschließend nach Hinzufügen von 180 g Methylenchlorid, 0,5 g Diazabicyclooctan (als 10 %ige Lösung in Methylglykolacetat) und weiteren 0,07 g p-Methoxyphenol mit 88 g (0,4 Mol) Isophorondiisocyanat zur Reaktion gebracht. Auch der aus diesem Harz in analoger Weise formulierte und abgeprüfte Resistlack zeigte keine Löslichkeit in Trichloräthylen oder Perchloräthan. Eine Entwicklung in einem Gemisch aus 3 Teilen Trichloräthan und 1 Teil Äthanol lieferte nur nach mechanischem Ausreiben der Schicht ein befriedigendes Relief. Auch hier erwies sich der trockene, auf dem Kupfer verbliebene Resistlack bei einer Knickprobe als wesentlich spröder und brüchiger als der in Beispiel 6 erhaltene Lackfilm.

Patentansprüche

1) Zusammensetzungen für die Herstellung von Trockenresistfilmen bzw. -folien auf der Grundlage von urethanisierten Umsetzungsprodukten aus 1,2-Polyepoxiden und olefinisch ungesättigten Carbonsäuren als fotopolymerisierbarem Bestandteil, üblichen Fotoinitiatoren, organischen Lösungsmitteln und ggf. üblichen Hilfsstoffen, dadurch gekennzeichnet, daß der fotopolymerisierbare Bestandteil aus einem Umsetzungsprodukt aus

a) einem Epoxyacrylat, erhalten durch Reaktion eines Diglycidylesters einer Hexahydrophthalsäure und Acryl- oder Methacrylsäure oder deren Mischungen, wobei 90-100 % der 1,2-Epoxidgruppen mit Methacrylsäure oder Acrylsäure verestert worden sind, und

b) Toluylendiisocyanat oder Isophorondiisocyanat, wobei zwei Grammäquivalente des Reaktionsproduktes a) mit 0,5 bis 0,9 Mol Diisocyanat zur Reaktion gebracht worden sind, besteht.

2) Lagerfähige, unvernetzte, fotopolymerisierbare Trockenresistfolie aus einer 5 - 100 µ dicken Kunststoffolie als Trägerfolie, einem 5 - 100 µ dicken, auf die Trägerfolie aufgebrachten Film einer fotopolymerisierbaren lösungsmittelfreien

Zusammensetzung auf der Grundlage von urethanisierten Umsetzungsprodukten aus 1,2-Polyepoxiden und olefinisch ungesättigten Carbonsäuren und üblichen Fotoinitiatoren sowie ggf. einer auf den fotopolymerisierbaren Film aufgebrachten Abdeckfolie, dadurch gekennzeichnet, daß das urethanisierte Umsetzungsprodukt aus

a) einem Epoxyacrylat, erhalten durch Reaktion eines Diglycidylesters einer Hexahydrophthalsäure und Acryl- oder Methacrylsäure oder deren Mischungen, wobei 90-100 % der 1,2-Epoxidgruppen mit Methacrylsäure oder Acrylsäure verestert worden sind, und

b) Toluylendiisocyanat oder Isophorondiisocyanat, wobei zwei Grammäquivalente des Reaktionsproduktes a) mit 0,5 bis 0,9 Mol Diisocyanat zur Reaktion gebracht worden sind, besteht.